# EUROPÄISCHE PATENTSCHRIFT

(11) **EP 1 544 627 B1**
(45) Veröffentlichungstag und Bekanntmachung des Hinweises auf die Patenterteilung: **28.07.2010**
(21) Anmeldenummer: 04028523.1
(22) Anmeldetag: 02.12.2004
(51) Int. Cl.: G01R 11/04

(54) **Anschlussvorrichtung für einen Stromzähler**
Connecting device for an electricity meter
Dispositif de raccordement pour un compteur d'électricité

(30) Priorität: 17.12.2003 DE 10359819
(43) Veröffentlichungstag der Anmeldung: 22.06.2005
(73) Patentinhaber: Hager Electro GmbH & Co. KG, 66440 Blieskastel (DE)
(72) Erfinder: Kelaiditis, Konstantin Dr.-Ing., 66386 St. Ingbert (DE); Zimmermann, Michael, 66399 Mandelbachtal (DE); Clemens, Guntram Dr.-Ing., 90409 Nürnberg (DE)
(74) Vertreter: Bernhardt, Winfrid

(56) Entgegenhaltungen:
- EP-A- 0 834 744
- DE-A1- 2 711 808
- DE-A1- 10 052 998
- DE-A1- 10 054 771
- DE-A1- 10 313 999
- US-A- 3 369 088
- PATENT ABSTRACTS OF JAPAN Bd. 012, Nr. 156 (P-701), 13. Mai 1988 (1988-05-13) -& JP 62 273460 A (TOKYO ELECTRIC POWER CO INC:THE; others: 03), 27. November 1987 (1987-11-27)

## Beschreibung

Die Erfindung betrifft eine Anschlussvorrichtung für einen Stromzähler, der ein Gehäuse aufweist, von dessen gegen eine Tragplatte anlegbarem Boden durch Öffnungen in der Tragplatte hindurchführbare Kontaktelemente entsprechend wenigstens einer Stromphase vorstehen, welche mit Anschlusselementen auf der dem Stromzähler abgewandten Seite der Tragplatte verbindbar sind, wobei die Anschlusselemente durch ein Teil 17 überbrückbar sind, das beim Anschluss des Stromzählers aus einer Überbrückungsposition in eine Öffnungsstellung bewegbar ist.

In der DE 100 52 998 A1 ist eine solche Anschlussvorrichtung beshrieben.

In der DE 100 54 771 A1 ist eine solche Anschlussvorrichtung mit einer Befestigungs- und Kontaktiereinrichtung für Elektrizitätszähler beschrieben, die eine steuerbare Überbrückungseinrichtung zum Kurzschließen der Zu- und Abgangsleitungen aufweist. Die Befestigungs- und Kontaktiereinrichtung wird relativ zu den Zu- und Abgangsleitungen in verschiedene, für den Anschluss des Elektrizitätszählers erforderliche Montagestellungen verschoben. Dabei wird die stets mit einer Leitung in Kontakt stehende Überbrückungseinrichtung senkrecht zur Verschiebungsrichtung der Befestigungs- und Kontaktiereinrichtung zwischen einer Kurzschlussstellung, bei der der Kontakt mit der anderen Leitung hergestellt wird, und zwei möglichen Offenstellungen bewegt. An der Befestigungs- und Kontaktiereinrichtung angeordnete Druckstifte können in eine Position gebracht werden, in der sie eine Kontaktdruckerhöhung an den Anschlusselementen verursachen.

Der Erfindung liegt die Aufgabe zugrunde, eine neue, konstruktiv vereinfachte Anschlussvorrichtung der eingangs genannten Art zu schaffen.

Die diese Aufgabe lösende Anschlussvorrichtungnach der Erfindung ist dadurch gekennzeichnet, dass die Kontaktelemente durch Verschiebung des auf der Tragplatte geführten Gehäuses auf der Tragplatte mit den Anschlusselementen verbindbar sind, dass das Überbrückungsteil in Verschiebungsrichtung des Stromzählers verschiebbar geführt und durch wenigstens eines der Kontaktelemente in die Offenstellung verschiebbar ist, und dass das wenigstens eine, das Überbrückungsteil verschiebende Kontaktelement gegen das Überbrückungsteil elektrisch isoliert ist.

Vorteilhaft bedarf es keiner Verschiebung einer Befestigungs- und Kontaktiereinrichtung. Zur Herstellung bzw. Aufhebung von Anschlussverbindungen wird der Stromzähler selbst-verschoben. Vorteilhaft ist durch die Isolierung ausgeschlossen, dass bei der Zählermontage, so lange die vom Zähler vorstehenden Kontaktelemente noch freiliegen, an Kontaktelementen eine Spannung anliegen kann.

Bei dem Kontaktelement handelt es sich vorzugsweise um einen flachen, über wenigstens eine Breitseite mit dem Anschlusselement verbindbaren Kontaktstreifen, der an seinen drei Schmalseiten rahmenartig durch ein Isolierstück eingefasst ist und vorzugsweise die gleiche Dicke wie das eingefasste Isolierstück aufweist.

Während es denkbar ist, dieses Isolierstück einstückig mit dem Gehäuse des Stromzählers zu verbinden, ist es in einer bevorzugten Ausführungsform der Erfindung mit einer hinter der Tragplatte angeordneten, parallel zur Tragplatte verschiebbaren Platte verbunden.

In der bevorzugten Ausführungsform der Erfindung ist das Überbrückungsteil durch einen Blechstreifen mit einer Randausnehmung ausgebildet, in welche das durch das Isolierstück isolierte Kontaktelement zwecks Verschiebung des Überbrückungsteils eingreift. Die Blechdicke ist der Dicke des Isolierstücks bzw. Kontaktelements angeglichen, so dass zwischen den Teilen keine Stufen gebildet sind, welche die Verschiebung des Überbrückungsteils durch das eingreifende Isolierstück bzw. Kontaktelement behindern.

Zweckmäßig ist die Platte derart geführt, dass ein seitlicher Austritt des Isolierstücks aus der Randausnehmung beim Verschieben des Überbrückungsteils verhindert wird.

Beim senkrechten Aufsetzen des Zählers auf die Tragplatte treten die Kontaktelemente in die diese Elemente rahmenartig einfassenden Isolierstücke ein. Zweckmäßig ist die betreffende Aussparung im Isolierstück entgegen der Eintrittsrichtung aufgeweitet, um den Eintritt der Kontaktelemente zu erleichtern.

In einer bevorzugten Ausführungsform der Erfindung lässt sich die Platte bei demontiertem Stromzähler in eine Parkstellung verschieben, in welcher die Überbrückungen durch das jeweilige Überbrückungsteil aufgehoben und die Öffnungen in der Tragplatte durch die verschobene Platte rückseitig abgedeckt sind.

Vorzugsweise ist die Platte in dieser Position durch eine plombierbare Einrichtung arretierbar.

Die Platte kann manuell verschiebbar sein, z.B. mit Hilfe eines Griffs, der durch ein Langloch in der Tragplatte ragt oder eine dem Boden des Stromzählers entsprechende Werkzeugvorrichtung

Daneben kommt für die Verschiebung der Platte auch ein elektromechanischer Antrieb in Betracht. Der elektromechanische Antrieb könnte durch einen Zeitschalter aktivierbar sein, so dass die Überbrückung nach einer vorgewählten Dauer automatisch aufgehoben wird.

An der Platte kann ferner ein Ansatz gebildet sein, der in dieser Parkstellung zum Andrücken der Kontaktelemente an die Anschlusselemente verwendete Schenkel eines Federteils in gegenseitigem Abstand hält.

Die Erfindung soll nun anhand eines Ausführungsbeispiels und der beiliegenden, sich auf dieses Ausführungsbeispiel beziehenden Zeichnungen näher erläutert werden. Es zeigen:
- Fig. 1: einen Teil eines zur Aufnahme eines elektronischen Stromzählers vorgesehenen Adapters, der an einem herkömmlichen Zählerplatz montierbar ist, in einer perspektivischen Ansicht schräg von vorne,
- Fig. 2: eine innerhalb des Adapters verschiebbare Platte, durch die eine Isolation gemäß der Erfindung verwirklicht ist, in einer perspektivischen Ansicht schräg von hinten,
- Fig. 3: eine oberhalb der Platte von Fig. 2 auf dem Adapterteil von Fig. 1 anzuord- nende Abdeckung in einer perspektivischen Ansicht schräg von hinten,
- Fig. 4: die Abdeckung von Fig. 3 in einer perspektivischen Ansicht schräg von vorne,
- Fig. 5: einen an den Adapter anschließbaren elektronischen Stromzähler in einer per- spektivischen Ansicht schräg von vorne,
- Fig. 6: einen Bodenteil des Stromzählers von Fig. 5 in einer perspektivischen Ansicht schräg von hinten,
- Fig. 7: die Platte von Fig. 2 mit darauf angeordneten Überbrückungsteilen in einer perspektivischen Ansicht schräg von hinten, und
- Fig. 8: den Adapterteil von Fig. 1 ohne eingesetzte Metallteile in einer perspektivi- schen Ansicht schräg von hinten.

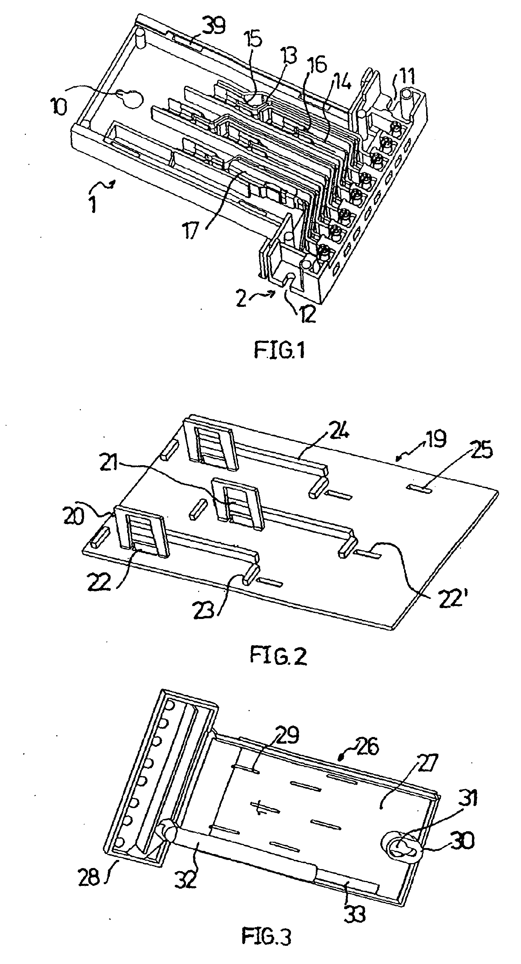

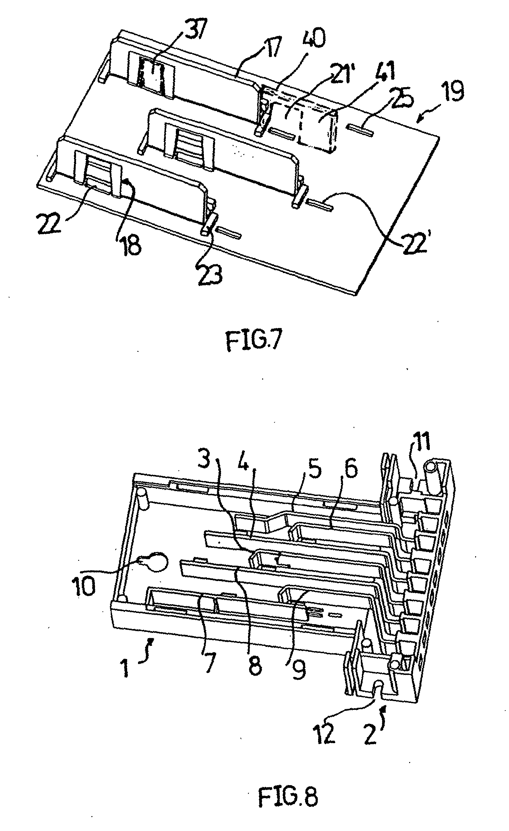

Ein in den Fig. 1 und 8 gezeigter, einstückig aus Kunststoffmaterial hergestellter Teil eines Adapters weist einen Abschnitt 1 in Form eines flachen Kastens und einen Abschnitt 2 in Form einer Anschlussleiste auf. Vom Boden des Kastenabschnitts 1 erstrecken sich bis in den Anschlussleistenabschnitt hineinreichende Stege 3 bis 9, die der gegenseitigen Isolierung von Anschlussleitern für drei Stromphasen dienen.

Eine Öffnung 10 im Boden des Kastenabschnitts 1 und langlochartige Randausschnitte 11 und 12 am Anschlussleistenabschnitt 2 dienen der Befestigung des Adapters am Zählerkreuz eines herkömmlichen Zählerplatzes.

Für jede der drei Stromphasen sind jeweils zwischen zwei der vorstehenden Isolierstege 3 bis 9 zwei Anschlusselemente 13 und 14 in Form massiver, vorgebogener Kupferblechstreifen angeordnet und zum Anschlussleistenabschnitt 2 geführt. Jedem der Anschlusselemente 13 und 14 ist ein am Kastenabschnitt 1 festgelegtes Federteil 15 bzw. 16 zugeordnet, das jeweils ein Paar einander gegenüberliegender Federschenkel aufweist, zwischen denen das betreffende Anschlusselement eingeklemmt ist.

Jedem der drei Paare von Anschlusselementen 13 und 14 ist ein Überbrückungsteil 17 in Form eines gewinkelten Blechstücks aus Kupfer zugeordnet. In Fig. 1 ist der Über sichtlichkeit halber nur eines dieser Überbrückungsteile gezeigt. Alle drei Überbrückungsteile 17 sind in Fig. 7 in Verbindung mit der Platte von Fig. 2 dargestellt.

Wie insbesondere Fig. 7 erkennen lässt, weist jedes der drei Überbrückungsteile, 17 eine Randausnehmung 18 auf. In die Randausnehmung 18 greift jeweils ein von der Platte 19 vorstehendes Isolierstück 20 ein. Jedes der einstückig mit der Kunststoffplatte 19 verbundenen Isolierstücke 20 weist seinerseits eine Aussparung 21 auf, die zu einer Schlitzöffnung 22 in der Platte 19 ausgerichtet ist.

Die Aussparung 21 ist zu der Schlitzöffnung 22 hin etwas aufgeweitet, wie aus Fig. 2 und 7 hervorgeht.

Auf der Platte 19 gebildete Stegvorsprünge 23 dienen als Anschlag für den betreffenden Überbrückungsteil 17. Drei weitere Stegvorsprünge, die jeweils im Abstand zu einem der Isolierstücke 20 angeordnet sind, bilden Führungen 24, welche gegen die obengenannten Stege 4, 5 und 8 im Kastenabschnitt 1 anliegen. Die Platte 19 weist weitere entsprechend den Ecken eines Dreiecks angeordnete Schlitzöffnungen 22' sowie eine Schlitzöffnung 25 auf.

Auf den Adapterteil und die in dessen Kastenabschnitt 1 eingelegte Platte 19 ist zur Komplettierung des Adapters eine in Fig. 3 gezeigte Abdeckung 26 mit einem Plattenabschnitt 27 und einem Anschlussleistenabschnitt 28 aufsetzbar. Der Plattenabschnitt 27 weist den Schlitzöffnungen 22,22' und 25 in der Platte 19 entsprechend angeordnete Schlitzöffnungen 29 auf, die länger als die jeweiligen Schlitzöffnungen in der Platte 19 sind.

Ein nach vorne offener, hohler Ansatz 30 an der Rückseite des Plattenabschnitts 27 weist eine zu der Öffnung 10 im Boden des Kastenabschnitts 1 deckungsgleiche Öffnung 31 auf.

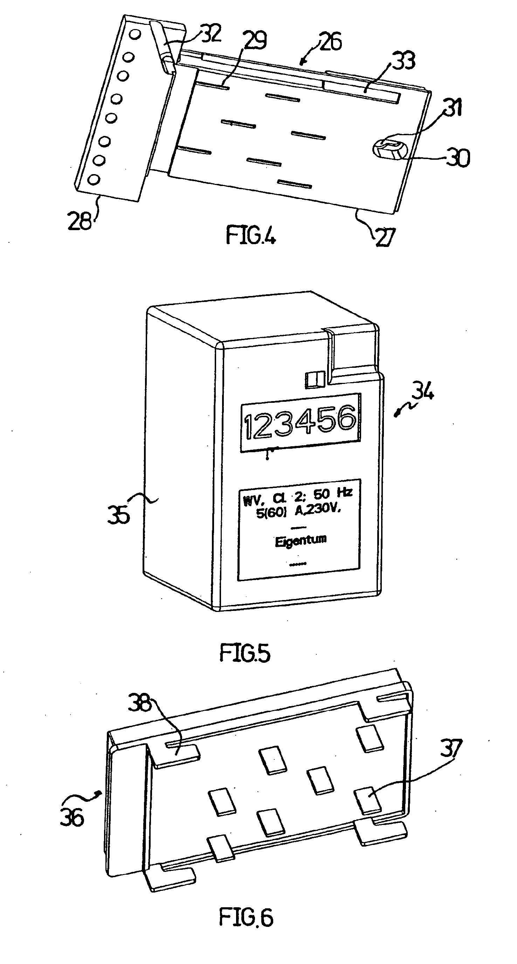

Schräg auf dem Anschlussleistenabschnitt 28 und über einen Teil der Länge des Plattenabschnitts 27 erstreckt sich am Rand des Plattenabschnitts 27 ein nach vorne offener Kanal 32 für die Verlegung von Signalleitungen zu einem in Fig. 5 und 6 gezeigten elektronischen Stromzähler. Eine zu dem Kanal 32 ausgerichtete Schlitzöffnung 33 in dem Plattenabschnitt 27 bietet Platz für erforderliche Leiterschleifen der Signalleitungen nahe der Anschlussstelle am Stromzähler.

Der in den Fig. 5 und 6 gezeigte Stromzähler 34 weist ein Kunststoffgehäuse 35 mit einem Bodenteil 36 auf. Aus dem isolierenden Kunststoffmaterial des Bodenteils treten insgesamt sieben Kontaktelemente 37 in Form von Blechstreifen hervor.

An den beiden Längsrändern des Bodenteils 36 sind jeweils zwei Hakenelemente 38 angeordnet, welche zum Eingriff in Schlitzöffnungen 39 am Kastenabschnitt 1 des in Fig. 1 gezeigten Adapterteils vorgesehen sind.

Beim Anschluss des Stromzählers 34 an den Adapter wird der Zähler auf den eine Tragplatte für den Zähler bildenden Plattenabschnitt 27 der Abdeckung 26 aufgesetzt. Die Hakenelemente 38 gelangen dabei in die Schlitzöffnungen 39 am Kastenabschnitt 1 des Adapterteils von Fig. 1 und die Kontaktelemente 37 treten durch die sieben Schlitze 29 im Plattenabschnitt 27 und dann durch die Schlitze 22,22' und 25 in der Platte 19 hindurch in den Kastenabschnitt 1 hinein, wobei drei der Kontaktelemente 37 in die Aussparungen 21 der Isolierstücke 20 an der Platte 19 gelangen, wobei die Isolierstücke 20 das betreffende Kontaktelement rahmenartig umfassen. Die Dicke des Kontaktelements und die Rahmendicke sind gleich. Die genannte Aufweitung der Aussparungen 21 erleichtert die Einführung der betreffenden Kontaktelemente.

In der Position des Zählers auf dem Plattenabschnitt 27, in welcher die Hakenelemente 38 in die Schlitzöffnungen 39 senkrecht zum Plattenabschnitt 27 eingeschoben werden können, sind die jeweiligen Anschlusselemente 14 und 15 noch durch das betreffende Überbrückungsteil 17 überbrückt. Die Kontaktelemente 37 werden von den jeweiligen Überbrückungselementen durch die Isolierstücke 20 elektrisch getrennt. An den Kontaktelementen 37 liegt keine den Monteur gefährdende Spannung.

Mit einer Verschiebung des Zählers 34 parallel zum Plattenabschnitt 27 hintergreifen die Hakenelemente 38 den betreffenden Endrand der Schlitzöffnungen 39, und der Stromzähler 34 ist auf dem Plattenabschnitt 27 gegen Abheben in zum Plattenabschnitt 27 senkrechter Richtung verriegelt. Mit der Verschiebung gelangen die durch die eingreifenden Kontaktelemente und/oder einen der Stegvorsprünge 23 bewegten Überbrückungsteile an einem Ende aus dem Kontakt mit dem betreffenden Anschlusselement 14 und jeweils eine Breitseite der flachen Kontaktelemente 37 liegt gegen das Anschlusselement 14 bzw. 15 an. Die Federschenkel der Federteile 15 und 16 pressen jeweils die Kontaktelemente gegen die Anschlusselemente. Der Zähler befindet sich in der Betriebsstellung. Durch eine nicht gezeigte plombierbare Arretierung kann diese Betriebsstellung fixiert werden.

Anschlusselemente für ein durch die Schlitzöffnung 25 geführtes Kontaktelement, welches den Nullleiter führt, sind in den Figuren nicht gezeigt.

Zur Demontage wird der Zähler in entgegengesetzter Richtung auf dem Plattenabschnitt 27 verschoben, wobei die über die Isolierstücke 20 in die Aussparungen 18 eingreifende Kontaktelemente 17 die Überbrückungsteile wieder rückverschieben und eine Überbrückung der drei Phasen hergestellt wird.

Die Platte 19 kann mit einer (nicht gezeigten) Verschiebeeinrichtung versehen sein, z.B. einem durch eine Schlitzöffnung im Plattenabschnitt 27 hindurchstehenden Griff, um die Platte 19 bei demontiertem Zähler zu verschieben, so dass die Überbrückung durch die Überbrückungsteile 17 aufgehoben ist, und noch weiter in eine Parkstellung zu überführen, in der auch die Schlitzöffnungen 29 im Plattenabschnitt 27 rückseitig durch die Platte abgedeckt sind. Zweckmäßig ist der Griff unter dem Zähler angeordnet.

Zweckmäßig ist eine plombierbare Arretierung der Platte in dieser Position vorgesehen.

Als Verschiebeeinrichtung käme auch ein elektromechanischer Antrieb für die Platte 19 in Betracht.

Zweckmäßig stehen von der Platte 19 weitere, beispielhaft in Fig. 7 bei 40 durch Strichlinien angedeutete Ansätze mit einer Aussparung 21' vor, welche in dieser Parkstellung verhindern, dass die Schenkel der Federteile 15,16 gegeneinander anliegen. In der Parkstellung sind die Überbrückungsteile über die der Betriebsstellung des Stromzählers entsprechende Stellung hinaus weiterverschoben, so dass die Schenkel der Federteile gegen einen Abschnitt 41 des Ansatzes 40 anliegen.

Abweichung von dem gezeigten Ausführungsbeispiel könnte die Isolation der Kontaktelemente 39 gegen die Überbrückungsteile 17 durch einen zwischen den Kontaktelementen und den Überbrückungsteilen belassenen Luftspalt hergestellt sein. Die Verschiebung der Überbrückungsteile 17 erfolgt dann ausschließlich über die einen Anschlag bildenden Stege 23.

Abweichend von dem gezeigten Ausführungsbeispiel könnten die Isolierstücke 20 von der Platte 19 getrennt und mit den Überbrückungsteilen verbunden sein. Sofern darüber hinaus die die Anschläge bildenden Stegvorsprünge 23 fehlen, ließe sich dann die Platte bei demontiertem Zähler unabhängig von den Überbrückungsteilen verschieben, z.B. in eine Position, in der die Schlitze in dem Tragplattenabschnitt rückseitig abgedeckt sind, so dass kein Zugang mehr zu den spannungsführenden Teilen besteht. Zweckmäßig könnte auch hier eine arretierbare Plombiereinrichtung für die Platte in der Verschlussstellung vorgesehen sein.

Die Überbrückungselemente könnten zur Verschiebung in eine Offenstellung bei demontiertem Zähler ggf. auch in umgekehrter Richtung als in dem beschriebenen Ausführungsbeispiel verschiebbar sein. Es wäre ferner denbkar, eine derart weite Verschiebung der Überbrückungsteile vorzusehen, dass die Überbrückungsteile nicht mehr zurückholbar und nutzbar sind.

## Patentansprüche

1. Anschlussvorrichtung für einen Stromzähler (34), der ein Gehäuse aufweist, von dessen gegen eine Tragplatte (27) der Anschlussvorrichtung anlegbarem Boden (36) durch Öffnungen (39) in der Tragplatte (27) hindurchführbare Kontaktelemente (37) entsprechend wenigstens einer Stromphase vorstehen, welche mit stromzu- und abführenden, Anschlusselementen der Anschlussvorrichtung (13,14) auf der dem Stromzähler (34) abgewandten Seite der Tragplatte (27) verbindbar sind, wobei die Anschlusselemente (13,14) durch ein Überbrückungsteil (17) der Anschlussvorrichtung überbrückbar sind, das beim Anschluss des Stromzählers (34) aus einer Überbrückungsposition in eine Offenstellung bewegbar ist, wobei
die Kontaktelemente (37) durch Verschiebung des auf der Tragplatte (27) geführten Gehäuses (35) auf der Tragplatte (27) mit den Anschlüsselementen (13,14) verbindbar sind, das Überbrückungsteil (17) in Verschiebungsrichtung des Stromzählers (34) verschiebbar geführt und durch wenigstens eines der Kontaktelemente (37) in die Offenstellung verschiebbar ist, und das wenigstens eine, das Überbrückungsteil (17) verschiebende Kontaktelement (37) beim Verschieben des Überbrückungsteils (17) gegen das Überbrückungsteil (17) elektrisch isoliert ist.

2. Anschlussvorrichtung nach Anspruch 1,
**dadurch gekennzeichnet,**
**dass** ein Isolierstück (20) und ein Kontaktelement (37) in Form eines flachen, über wenigstens eine Breitseite mit dem Anschlusselement (13,14) verbindbaren Kontaktstreifens vorgesehen sind, wobei das Kontaktelement an seinen drei Schmalseiten durch das Isolierstück (20) rahmenartig eingefasst ist.

3. Anschlussvorrichtung nach Anspruch 2,
**dadurch gekennzeichnet,**
**dass** die Dicke des Isolierstücks (20) gleich der Dicke des Kontaktelements (37) ist.

4. Anschlussvorrichtung nach Anspruch 2 oder 3,
**dadurch gekennzeichnet,**
**dass** das Isolierstück (20) mit einer hinter der Tragplatte (27) angeordneten, parallel zur Tragplatte (27) verschiebbaren Platte (19) verbunden ist.

5. Anschlussvorrichtung nach einem der Ansprüche 2 bis 4,
**dadurch gekennzeichnet,**
**dass** das Isolierstück (20) und das durch das Isolierstück isolierte Kontaktelement (37) in eine Randausnehmung (18) eingreifen, die in einem das Überbrückungsteil (17) bildenden Blechstreifen vorgesehen ist.

6. Anschlussvorrichtung nach Anspruch 5,
**dadurch gekennzeichnet,**
**dass** die Platte (19) eine ein seitliches Austreten des Isolierstücks (20) aus der Randausnehmung (18) verhindernde Führung (24) aufweist.

7. Anschlussvorrichtung nach Anspruch 5 oder 6,
**dadurch gekennzeichnet,**
**dass** die Randausnehmung (18) entgegen der Einschubrichtung des isolierten Kontaktelements aufgeweitet ist.

8. Anschlussvorrichtung nach einem der Ansprüche 5 bis 7,
**dadurch gekennzeichnet,**
**dass** die Platte (19) bei von der Anschlussvorrichtung abgenommenem Stromzähler (34) in eine Position verschiebbar ist, in welcher die Überbrückung der Anschlusselemente durch das Überbrückungsteil (17) aufgehoben ist und die Öffnungen in der Tragplatte (27) geschlossen sind.

9. Anschlussvorrichtung nach Anspruch 8,
**dadurch gekennzeichnet,**
**dass** die Platte in der genannten Position durch eine, vorzugsweise plombierbare, Einrichtung arretierbar ist.

10. Anschlussvorrichtung nach Anspruch 8 oder 9,
**dadurch gekennzeichnet,**
**dass** die Platte manuell mit Hilfe eines mit der Platte verbundenen oder verbindbaren Griffteils, eines Werkzeugs oder/und elektromechanisch verschiebbar ist.

11. Anschlussvorrichtung nach einem der Ansprüche 8 bis 10,
**dadurch gekennzeichnet,**
**dass** die Platte (19) wenigstens einen Ansatz (40) aufweist, welcher in der genannten Position die Schenkel einer zum Zusammenpressen eines Anschluss- und eines Kontaktelements vorgesehenen Feder (15,16) auseinanderhält.

## Claims

1. Connection apparatus for an electricity meter (34) which has a housing, with contact elements (37) which can be passed through openings (39) in a mounting plate (27) of the connection apparatus projecting from the base (36) of the housing, which base can be fitted to the mounting plate (27), in accordance with at least one current phase, it being possible for the said contact elements to be connected to current-supplying and current-emitting connection elements (13, 14) of the connection apparatus on that side of the mounting plate (27) which is averted from the electricity meter (34), it being possible for the connection elements (13, 14) to be bridged by a bridging part (17) of the connection apparatus, it being possible for the said bridging part to be moved from a bridging position to an open position when the electricity meter (34) is connected, it being possible for the contact elements (37) to be connected to the connection elements (13, 14) by displacing the housing (35), which is guided on the mounting plate (27), on the mounting plate (27), the bridging part (17) being displaceably guided in the displacement direction of the electricity meter (34) and it being possible for the said bridging part to be displaced into the open position by at least one of the contact elements (37), and the at least one contact element (37), which displaces the bridging part (17), being electrically insulated from the bridging part (17) when the bridging part (17) is displaced.

2. Connection apparatus according to Claim 1, **characterized in that** an insulating piece (20) and a contact element (37) in the form of a flat contact strip which can be connected to the connection element (13, 14) by means of at least one broad side are provided, the contact element being held on its three narrow sides in a frame-like manner by the insulating piece (20).

3. Connection apparatus according to Claim 2, **characterized in that** the thickness of the insulating piece (20) is equal to the thickness of the contact element (37).

4. Connection apparatus according to Claim 2 or 3, **characterized in that** the insulating piece (20) is connected to a plate (19) which is arranged behind the mounting plate (27) and can be displaced parallel to the mounting plate (27).

5. Connection apparatus according to one of Claims 1 to 4, **characterized in that** the insulating piece (20) and the contact element (37) which is insulated by the insulating piece engage in an edge recess (18) which is provided in a sheet metal strip which forms the bridging part (17).

6. Connection apparatus according to Claim 5, **characterized in that** the plate (19) has a guide (24) which prevents the insulating piece (20) escaping from the sides of the edge recess (18).

7. Connection apparatus according to Claim 5 or 6, **characterized in that** the edge recess (18) is widened in relation to the insertion direction of the insulated contact element.

8. Connection apparatus according to one of Claims 5 to 7, **characterized in that**, when the electricity meter (34) is removed from the connection apparatus, the plate (19) can be displaced into a position in which bridging of the connection elements by the bridging part (17) is cancelled and the openings in the mounting plate (27) are closed.

9. Connection apparatus according to Claim 8, **characterized in that** the plate can be locked in the said position by a device which can preferably be lead-sealed.

10. Connection apparatus according to Claim 8 or 9, **characterized in that** the plate can be displaced manually with the aid of a handle part which is connected or can be connected to the plate, with the aid of a tool and/or electromechanically.

11. Connection apparatus according to one of Claims 8 to 10, **characterized in that** the plate (19) has at least one projection (40) which keeps apart the limbs of a spring (15, 16), which is provided for pressing together a connection element and a contact element, in the said position.

## Revendications

1. Dispositif de raccordement pour un compteur électrique (34), qui comprend un boîtier, depuis le fond (36) duquel, susceptible d'être appliqué contre une plaque porteuse (27) du dispositif de raccordement, des éléments de contact (37) correspondant à au moins une phase du courant électrique dépassent en traversant des ouvertures (39) dans la plaque porteuse (27), ces éléments de contact pouvant être raccordés à des éléments de raccordement (13, 14) pour l'amenée et le retour du courant, sur le côté détourné du compteur électrique (34), lesdits éléments de raccordement (13, 14) pouvant être pontés par une pièce de pontage (17) du dispositif de raccordement, pièce qui est déplaçable lors du raccordement du compteur électrique (34) depuis une position de pontage jusque dans une position ouverte,
dans lequel
les éléments de contact (37) peuvent être reliés avec les éléments de raccordement (13, 14) par translation sur la plaque porteuse (27) du boîtier (35) guidé sur la plaque porteuse (27), la pièce de pontage (17) est guidée en translation dans la direction de translation du compteur électrique (34) et peut être passée par l'un au moins des éléments de contact (37) vers la position ouverte, et ledit au moins un élément de contact (37) qui déplace la pièce de pontage (17) est électriquement isolé par rapport à la pièce de pontage (17) lors de la translation de la pièce de pontage (17).

2. Dispositif de raccordement selon la revendication 1,
**caractérisé en ce qu'**il est prévu une pièce d'isolation (20) et un élément de contact (37) sous la forme d'un ruban de contact plat susceptible d'être relié à l'élément de raccordement (13, 14) via au moins un côté large, et l'élément de contact est enchâssé sur ses trois petits côtés par la pièce d'isolation (20) à la manière d'un cadre.

3. Dispositif de raccordement selon la revendication 2,
**caractérisé en ce que** l'épaisseur de la pièce d'isolation (20) est égale à l'épaisseur de l'élément de contact (37).

4. Dispositif de raccordement selon la revendication 2 ou 3,
**caractérisé en ce que** la pièce d'isolation (20) est reliée à une plaque (19) agencée derrière la plaque porteuse (27) et susceptible d'être déplacée parallèlement à la plaque porteuse (27).

5. Dispositif de raccordement selon l'une des revendications 2 à 4,
**caractérisé en ce que** la pièce d'isolation (20) et l'élément de contact (37) isolé par la pièce d'isolation s'engagent dans un évidement de bordure (18) qui est ménagé dans un ruban de tôle qui forme la pièce de pontage (17).

6. Dispositif de raccordement selon la revendication 5,
**caractérisé en ce que** la plaque (19) comprend un guidage (24) qui empêche une sortie de la pièce d'isolation (20) latéralement hors de l'évidement de bordure (18).

7. Dispositif de raccordement selon la revendication 5 ou 6,
**caractérisé en ce que** l'évidement de bordure (18) est élargi en sens opposé à la direction d'introduction de l'élément de contact isolé.

8. Dispositif de raccordement selon l'une des revendications 5 à 7,
**caractérisé en ce que** la plaque (19), lorsque le compteur électrique (34) est enlevé du dispositif de raccordement, est déplaçable jusque dans une position dans laquelle la mise en pontage des éléments de raccordement par la pièce de pontage (17) est annulée et les ouvertures dans la plaque porteuse (27) sont fermées.

9. Dispositif de raccordement selon la revendication 8,
**caractérisé en ce que** la plaque est susceptible d'être arrêtée dans la position précitée par un système, de préférence capable d'être plombé.

10. Dispositif de raccordement selon la revendication 8 ou 9,
**caractérisé en ce que** la plaque est déplaçable manuellement à l'aide d'une partie formant poignée reliée ou susceptible d'être reliée à la plaque, à l'aide d'un outil et/ou par voie électromécanique.

11. Dispositif de raccordement selon l'une des revendications 8 à 10,
**caractérisé en ce que** la plaque (19) comprend au moins un talon (40) qui, dans la position précitée, maintient écartées les branches d'un ressort (15, 16) prévu pour presser ensemble un élément de raccordement et un élément de contact.
